# EUROPÄISCHE PATENTSCHRIFT

(11) **EP 0 911 860 B1**
(45) Veröffentlichungstag und Bekanntmachung des Hinweises auf die Patenterteilung: **11.06.2003**
(21) Anmeldenummer: 98117973.2
(22) Anmeldetag: 22.09.1998
(51) Int. Cl.: H01J 37/05

(54) **Teilchenstrahlgerät mit Energiefilter**
Particle beam apparatus with energy filter
Appareil à faisceau de particules chargées avec filtre en énergie

(30) Priorität: 23.10.1997 DE 19746785
(43) Veröffentlichungstag der Anmeldung: 28.04.1999
(73) Patentinhaber: LEO Elektronenmikroskopie GmbH, 73446 Oberkochen (DE)
(72) Erfinder: Weimer, Eugen,Dr., 73457 Essingen (DE); Bihr, Johannes, 73431 Aalen (DE)
(74) Vertreter: Gnatzig, Klaus

(56) Entgegenhaltungen:
- EP-A- 0 218 920
- US-A- 5 502 306
- ROSE H: "ELECTROSTATIC ENERGY FILTER AS MONOCHROMATOR OF A HIGHLY COHERENT ELECTRON SOURCE" OPTIK,DE,WISSENSCHAFTLICHE VERLAG GMBH.STUTTGART, Bd. 86, Nr. 3, 1. Dezember 1990 (1990-12-01), Seiten 95-98, XP000179868 ISSN: 0030-4026
- "COLLECTOR FOR SECONDARY ELECTRONS EMITTED IN AN SEM OF REDUCED LANDING ENERGY" IBM TECHNICAL DISCLOSURE BULLETIN,US,IBM CORP. NEW YORK, Bd. 32, Nr. 8A, 1990, Seiten 140-141, XP000082742 ISSN: 0018-8689

## Beschreibung

Teilchenstrahlgeräte in Form von Transmissionselektronenmikroskopen mit Energiefiltern sind beispielsweise aus den US 4,740,704, US 4,760,261 und US 5,449,914 bekannt. Die in diesen Schriften beschriebenen Energiefilter sind dispersiv, d.h. ein in das Filter eintretendes geladenes Teilchen erfährt bei Durchlaufen des Filters eine von der Teilchenenergie abhängige Ablenkung. Das in der US 4,740,704 beschriebene Filter wird beim Transmissionselektronenmikroskop 912 Omega der Anmelderin eingesetzt. Beim 912 Omega ist das Filter im Abbildungsstrahlengang zwischen der zu untersuchenden Probe und dem Projektionsschirm bzw. der Kamera, auf die die Probe elektronenoptisch abgebildet wird, angeordnet. Mit einem solchen abbildungsseitigen Energiefilter kann der Energieverlust, den die Teilchen in der Probe erfahren haben, analysiert werden. Gleichzeitig können die von der Energie abhängigen Abbildungsfehler, die chromatischen Aberrationen, im Abbildungsstrahlengang reduziert werden, da nur Teilchen mit einer reduzierten Energiebandbreite zur Abbildung beitragen.

Zur Korrektur der chromatischen Abbildungsfehler sowohl bei Rasterelektronenmikroskopen als auch bei Transmissionselektronenmikroskopen ist es aus der US 5,319,207 bekannt, im Beleuchtungsstrahlengang zwischen der Elektronenquelle und der zu untersuchenden Probe einen Spiegelkorrektor vorzusehen. Der dort beschriebene Spiegelkorrektor besteht aus einem magnetischen Strahlumlenker und einem elektrostatischen Spiegel, der zwei Symmetrieebenen innerhalb des magnetischen Strahlumlenkers ineinander abbildet. Obwohl der Strahlumlenker dispersive Eigenschaften aufweist, ist der Korrektor insgesamt nicht dispersiv, d.h., in den Korrektor eintretende Teilchen erfahren nach vollständigem Durchlaufen des Korrektors keine von der Teilchenenergie abhängige Ablenkung.

Derartige Korrektoren sind jedoch relativ aufwendig und werden bisher nicht kommerziell angeboten.

Als Alternative zu einem Korrektor ist es aus einem Aufsatz in Optik, Band 86 (Nr. 3), Seiten 95 bis 98, (1990) bekannt, bei einem Transmissionselektronenmikroskop im Beleuchtungsstrahlengang ein Energiefilter vorzusehen Entsprechend des Oberbegriffs des Anspruchs 1. Durch die bewirkte Energiefilterung lassen sich zumindest die energieabhängigen Fehler aufgrund der geringen Energiebandbreite der zur nachfolgenden Abbildung beitragenden Teilchen reduzieren. Obwohl auch hier das Filter für die energetische Aufspaltung des Teilchenstrahls dispersive Elemente aufweist, ist das Filter insgesamt dispersionsfrei, sodaß die in das Filter eintretenden Teilchen nach vollständigem Durchlauf des Filters wiederum keine von der Energie abhängige Ablenkung erfahren. Die Dispersionsfreiheit des Gesamtfilters wird dadurch erreicht, daß das Filter symmetrisch zu einer Mittelebene ist und die Dispersion in den beiden zueinander symmetrischen Filterteilen exakt entgegengesetzt ist. Durch diese Dispersionsfreiheit des Filters wird sichergestellt, daß geringfügige Spannungsschwankungen am Filter nicht zu einer Strahlauswanderung hinter dem Filter führen. Dispersionsfreie Filter haben jedoch den Nachteil, daß die in der Energieauswahlebene, in der die Energieselektion mit Hilfe einer Spaltblende erfolgt, erreichbare Dispersion relativ gering ist. Und da die Dispersion allgemein von der Teilchenenergie abhängig ist und mit zunehmender Teilchenenergie abnimmt, muß die Teilchenenergie innerhalb des Filters relativ niedrig sein, wenn eine hohe Energieschärfe erreicht werden soll. In dem Aufsatz wird von einer Teilchenenergie von 3 keV ausgegangen, wobei in weiterführenden Arbeiten von H. Rose ein sinnvoller Energiebereich von 3 bis 5 keV spezifiziert wurde. Bei niedrigen Teilchenenergien innerhalb des Filters resultiert jedoch aufgrund des sogenannten Boerscheffektes eine Verbreiterung der Energiebandbreite. Da der Boerscheffekt insbesondere bei Zwischenabbildungen der Teilchenquelle innerhalb des Filters aufgrund der höheren Teilchendichte in solchen Zwischenbildern signifikante Wirkungen hat, wurde von H. Rose bereits der Einsatz eines Filters mit ausschließlich astigmatischen Zwischenbildern innerhalb des Filters vorgeschlagen.

Aus der JP 62-93848 ist desweiteren ein Rasterelektronenmikroskop mit einem dispersiven Energiefilter zwischen der Quelle und dem Objektiv bekannt. Bei dem hier beschriebenen System wird das Filter jedoch lediglich zur Erzeugung eines Relativsignals verwendet, so daß durch Quotientenbildung zwischen dem eigentlichen Sekundärelektronen-Meßsignal und dem Relativsignal die negativen Einflüsse des Rauschens der Elektronenquelle auf das nachfolgend erzeugte Bild eliminiert werden können.

Die vorliegende Erfindung soll ein Teilchenstrahlgerät angeben, bei dem der zur weiteren Abbildung bzw. Bilderzeugung verwendete Teilchenstrahl eine hohe Energieschärfe aufweisen kann und bei dem der Einfluß des Boerscheffektes gering ist.

Dieses Ziel wird durch ein Teilchenstrahlgerät mit den Merkmalen des Anspruches 1 gelöst. Vorteilhafte Ausgestaltungen der Erfindung ergeben sich aus den Merkmalen der abhängigen Ansprüche.

Beim erfindungsgemäßen Teilchenstrahlgerät ist beleuchtungsseitig, zwischen dem Teilchenstrahlerzeuger und einem Objektiv wie in dem o.g. Aufsatz ein Energiefilter angeordnet. Im Gegensatz zu der Anordnung nach dem o.g. Aufsatz weist dieses Energiefilter jedoch eine Dispersion auf, d.h. die Teilchen, die das gesamte Filter durchlaufen haben, weisen am Ende des Filters eine von Ihrer kinetischen Energie abhängige Ablenkung auf. Es handelt sich dabei um ein sogenanntes abbildendes Energiefilter, das eine erste eingangsseitige Ebene achromatisch in eine ausgangsseitige Ebene abbildet und gleichzeitig eine zweite eingangsseitige Ebene dispersiv in eine zweite ausgangsseitige Ebene abbildet. Der Teilchenstrahlerzeuger - genauer gesagt, die die Teilchen emittierende Fläche des Teilchenstrahlerzeugers - wird beim erfindungsgemäßen Teilchenstrahlgerät in die erste eingangsseitige Ebene des Energiefilters abgebildet, so daß trotz der Dispersion des Energiefilters Energieschwankungen des Teilchenstrahls zu keinerlei Auswanderung des Bildes des Teilchenstrahlerzeugers in und hinter der zweiten ausgangsseitigen Ebene führen.

Da dispersive Energiefilter eine höhere Dispersion als dispersionsfreie Energiefilter aufweisen, kann die mittlere Teilchenenergie beim erfindungsgemäßen Teilchenstrahlgerät bei gleicher Energieschärfe des energiegefilterten Teilchenstrahls höher gewählt werden als nach dem Stand der Technik. Aufgrund dieser höheren mittleren Teilchenenergie, die zwischen 5 und 35 keV liegen kann und vorzugsweise etwa 8 bis 20 keV betragen sollte, sind die negativen Einflüsse des Boerscheffektes deutlich reduziert.

Die Energieselektion durch eine entsprechende spaltförmige Selektionsblende kann beim erfindungsgemäßen Teilchenstrahlgerät im ausgangsseitigen Bereich des Energiefilters bzw. hinter dem Energiefilter in der zweiten ausgangsseitigen Ebene erfolgen.

Die Abbildung des Teilchenstrahlerzeugers in die erste eingangsseitige Ebene erfolgt vorzugsweise derart vergrößert, daß durch die Energieselektion hinter dem Energiefilter keine Beschneidung der Apertur des Teilchenstrahls im nachfolgenden Strahlengang erfolgt.

Bei einem vorteilhaften Ausführungsbeispiel der Erfindung werden die Teilchen bereits vor Eintritt in das Energiefilter auf eine relativ hohe Energie beschleunigt und durchlaufen sowohl das Energiefilter als auch die nachfolgenden Abbildungsstufen mit der selben Energie und werden erst im Objektiv oder zwischen Objektiv und der zu untersuchenden Probe auf die geringere gewünschte Endenergie abgebremst. Diese Ausführungsform des erfindungsgemäßen Teilchenstrahlgerätes kann insbesondere als Niederspannungs-Rasterelektronenmikroskop ausgebildet sein, bei dem der Teilchenstrahl vom Objektiv auf die zu untersuchende Probe fokussiert wird. Zum Abrastern der Probe ist dann im Bereich des Objektivs eine Ablenkeinrichtung, mit der der Teilchenstrahlfokus in zwei zueinander senkrechten Richtungen ablenkbar ist, vorgesehen. Die Zielenergien liegen bei solchen Niederspannungs-Rasterelektronenmikroskopen zwischen 10 eV und 10 keV.

Bei einem solchen Niederspannungs-Rasterelektronenmikroskop kann zwischen dem Objektiv und dem Filter ein Detektor zum Nachweis von aus der zu untersuchenden Probe emittierten Sekundärelektronen vorgesehen sein. Für einen Nachweis der von der Probe zurückgestreuten Teilchen kann ein weiterer Detektor vorgesehen sein, wobei der Strahlengang dieser zurückgestreuten Teilchen vorzugsweise vom Energiefilter seitlich ausgekoppelt wird. Zur Trennung der unmittelbar zurückgestreuten Teilchen von solchen Teilchen, die einen Energieverlust erfahren haben, kann zwischen dem Filter und dem Detektor zum Nachweis der zurückgestreuten Teilchen noch eine Spaltblende angeordnet sein.

Alternativ zur Ausführungsform als Niederspannungs-Rasterelektronenmikroskop kann das erfindungsgemäße Teilchenstrahlgerät natürlich auch als Hochspannungs-Transmissionselektronenmikroskop ausgebildet sein. In diesem Fall würde der Teilchenstrahl unmittelbar nach Austritt aus dem Energiefilter auf die gewünschte hohe Zielenergie beschleunigt werden.

Die Dispersion des Energiefilters sollte bei der mittleren Teilchenenergie innerhalb des Filters im Bereich zwischen 5 bis 20 µm/eV, vorzugsweise zwischen 10 und 15 µm/eV liegen. Denn liegt die Dispersion des Filters unter 5 bis 10 µm/eV, so lassen sich keine hinreichenden Energieschärfen erreichen bzw. werden zu kleine Spaltbreiten der Selektionsblende erforderlich. Wird der obere Grenzwert von 15 bis 20 µm/eV überschritten, so wird die Apertur des Teilchenstrahls hinter der Selektionsblende zu groß mit der Folge, daß die nachfolgenden elektronenoptischen Abbildungselemente größere Öffnungsfehler erzeugen, wodurch der durch die Reduzierung der chromatischen Fehler mögliche Auflösungsgewinn wieder kompensiert oder sogar überkompensiert wird.

Nachfolgend werden Einzelheiten der Erfindung anhand der in den Figuren dargestellten Ausführungsbeispiele näher erläutert. Im einzelnen zeigen:
- Figur 1: einen Schnitt durch die elektronenoptischen Komponenten eines erfindungsgemäßen Teilchenstrahlgerätes in Form eines Niederspannungs-Rasterelektronenmikroskops;
- Figur 2: den Prinzipstrahlengang in einem Niederspannungs-Rasterelektronenmikroskop nach Figur 1;
- Figur 3: eine Prinzipskizze des quellenseitigen Teils eines erfindungsgemäßen Teilchenstrahlgerätes mit einem elektrostatischen Kondensor;
- Figuren 4a und 4b: zwei weitere alternative Ausführungsbeispiele der Objektivlinse für ein Niederspannungs-Rasterelektronenmikroskop nach Figur 1.

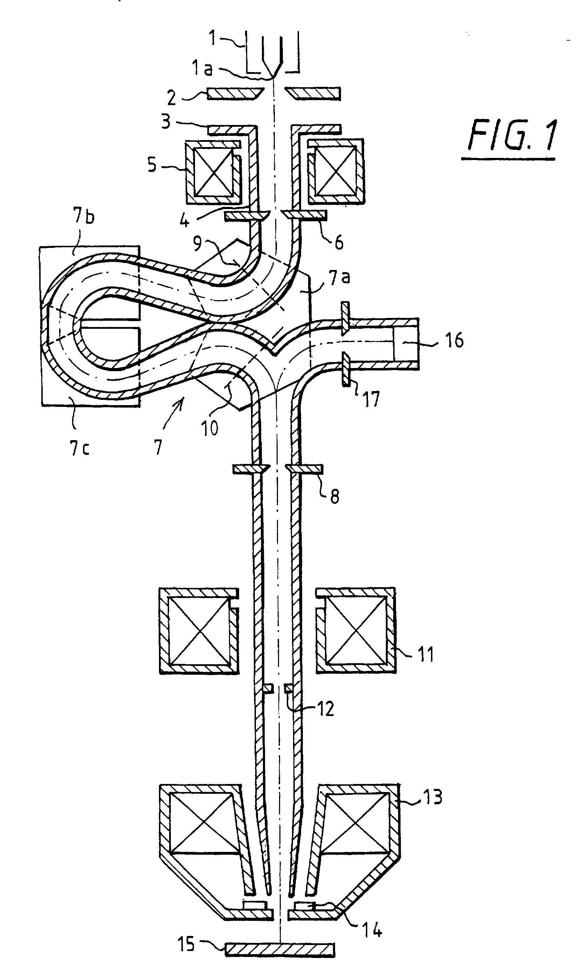

In der Figur 1 ist der Strahlerzeuger in Form einer thermischen Feldemissionsquelle insgesamt mit (1) und die die Elektronen emittierende Kathodenspitze mit (1a) bezeichnet. Aus der Kathodenspitze (1a) werden mit Hilfe der gegenüber der Kathodenspitze (1a) auf einem positiven Potential liegenden Extraktionselektrode (2) die Elektronen extrahiert und nachfolgend auf das Potential der Anode (3) beschleunigt. Die Anode (3) ist elektrisch leitend mit einem durch das gesamte Gerät hindurchgeführten Strahlführungsrohr (4) aus elektrisch leitendem Material verbunden. Das Anodenpotential und damit das Potential des Strahlführungsrohres (4) beträgt gegenüber dem Massepotential etwa 10 kV. Der Anode (3) folgt unmittelbar eine magnetische Kondensorlinse (5) und der Kondensorlinse (5) eine Aperturblende (6) nach. Das Energiefilter (7) ist ein abbildendes dispersives Elektronenenergiefilter, das eine sogenannte Eingangsbildebene (9) (erste eingangsseitige Ebene) stigmatisch und achromatisch in eine Ausgangsbildebene (10) (erste ausgangsseitige Ebene) und gleichzeitig eine Eingangsbeugungsebene (zweite eingangsseitige Ebene) dispersiv und stigmatisch in eine Ausgangsbeugungsebene (zweite ausgangsseitige Ebene) abbildet. In der Eingangsbeugungsebene ist die Aperturblende (6) angeordnet, d.h. diese Ebene fällt mit der Ebene der Aperturblende (6) zusammen. In der Ausgangsbeugungsebene ist die als Spaltblende ausgeführte Energieselektionsblende (8) angeordnet. Das dispersive Filter (7) selbst ist ein rein magnetisches Filter, wobei mit (7a - 7c) die drei Magnetsektoren des Filters bezeichnet sind. Der detaillierte Aufbau des Filters ist in der US-A 4 740 704 beschrieben, auf die bezüglich konstruktiver Details des Filters verwiesen sei.

Trotz des zu einer zur Zeichenebene in Figur 1 senkrechten Ebene symmetrischen Aufbaus des Filters (7) weist dieses eine Dispersion auf, d.h., die durch das Filter hindurchgelaufenen Elektronen weisen hinter dem Filter eine von ihrer Energie abhängige Ablenkung senkrecht zur optischen Achse auf, so daß durch eine Selektionsblende (8) mit einem zentralen Spalt diejenigen Elektronen, deren Energieabweichung von der Mittenenergie größer als die durch Dispersion und Spaltbreite definierte Energieabweichung ist, abgefangen werden. Damit Hochspannungsschwankungen keine laterale Wanderung der nachfolgenden Bilder der die Elektronen emittierenden Kathodenspitze (1a) verursachen, ist die Kathodenspitze (1a) von der Kondensorlinse (5) in die Eingangsbildebene (9) des Filters (7) abgebildet, die ja vom Filter (7) achromatisch in die Ausgangsbildebene (10) abgebildet wird.

Der Energieselektionsblende (8) folgt eine zweite Kondensorlinse (11) nach, durch die die Selektionsblende (8) in die hintere Brennebene der Objektivlinse (13) abgebildet wird. Gleichzeitig erzeugt die Kondensorlinse (11) durch Abbildung der Ausgangsbildebene (10) des Filters (7) ein weiteres Zwischenbild der Kathodenspitze (1a), das von der nachfolgenden Objektivlinse (13) noch einmal stark verkleinert auf die zu untersuchende Probe (15) abgebildet wird. Die Objektivlinse (13) ist dabei eine Kombination aus einer magnetischen und elektrostatischen Linse. Die Probe (15) und die Polschuhe der Objektivlinse (13) liegen auf Massepotential, so daß die Elektronen nach Austritt aus dem Strahlführungsrohr (4) im wesentlichen zwischen dem Ende des Strahlführungsrohres (4) und dem äußeren Polschuh der Objektivlinse (13) auf die Zielenergie zwischen 10 eV und 5 keV abgebremst werden. Zur Abrasterung eines größeren lateralen Bereiches der Probe (15) ist im Polschuhspalt der Objektivlinse (13) noch ein magnetisches Ablenksystem (14) angeordnet.

Für den Nachweis der aus der Probe (15) austretenden Sekundärelektronen ist zwischen der Objektivlinse (13) und der zweiten Kondensorlinse (11) ein rotationssymmetrischer Elektronendetektor mit Mittenbohrung angeordnet. Dieser Detektor kann als Szintillationsdetektor, Halbleiterdetektor oder Mikrokanalplattendetektor ausgebildet sein.

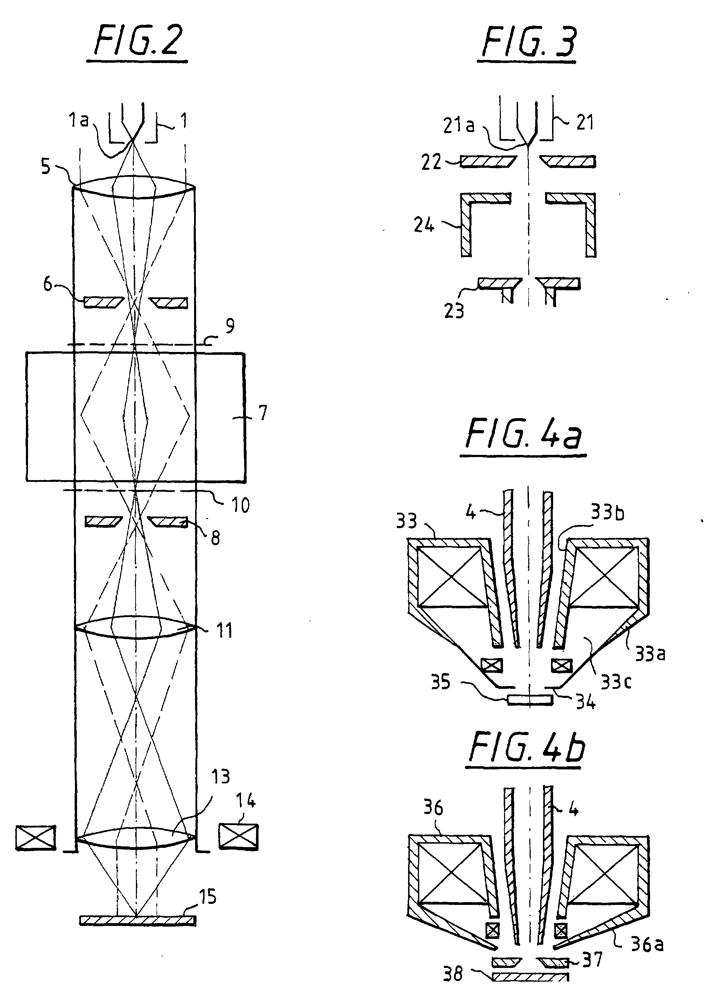

Der detaillierte elektronenoptische Strahlengang ist in der Figur 2 dargestellt. Durch die erste Kondensorlinse (5) wird die die Elektronen emittierende Kathodenspitze (1a) in die Eingangsbildebene (9) des dispersiven Filters (7), die vom Filter (7) achromatisch und stigmatisch in die Ausgangsbildebene (10) abgebildet wird, abgebildet. Die Aperturblende (6) ist zwischen der ersten Kondensorlinse (5) und der Eingangsbildebene (9) des Filters (7) in derjenigen Ebene angeordnet, die durch das Filter (7) stigmatisch dispersiv in die ausgangsseitige konjugierte Ebene, in der die Selektionsblende (8) angeordnet ist, abgebildet wird. Die Abbildung der Kathodenspitze (1a) in die Eingangsbildebene (9) erfolgt dabei mit einem Vergrößerungsmaßstab von 5 bis 40, wodurch sich eine entsprechende Reduzierung der wirksamen Apertur innerhalb des Filters (7) und in der Ebene der Selektionsblende (8) ergibt. Die Energiefilterung austrittsseitig des Filters (7) führt dadurch zu keiner nennenswerten Beschneidung der Apertur des Elektronenstrahlenbündels.

Wenn das Energiefilter bei einer Elektronenenergie von 10 keV eine Dispersion von 10 bis 15 µm/eV aufweist, wird mit einer Selektionsblende (8), die eine Spaltbreite von 2 µm aufweist, eine Energiebreite von 0,1 bis 0,2 eV eingestellt. Da der Abstand zwischen der Eingangsbildebene (9) und der Eingangsbeugungsebene (6) bei typischen dispersiven Energiefiltern 40 bis 80 mm beträgt, wird trotz der kleinen Spaltbreite eine Apertur von 1,5 x 10⁻⁵ problemlos übertragen. Mit dem anschließenden zweistufigen Abbildungssystem aus zweiter Kondensorlinse (11) und Objektivlinse (13), durch die das in der Ausgangsbildebene (10) entstehende Bild der Sondenspitze (1a) mit einem Abbildungsmaßstab von ca. 400 bis 700 mal verkleinert auf das Objekt (15) abgebildet wird, ergeben sich dann in der Probenebene optimale Endaperturen im Bereich von 6 x 10⁻³ bis 1 x 10⁻² und Sondengrößen zwischen ca. 1nm und 3nm.

Die an der Probe 15 zurückgestreuten Elektronen werden von dem Verzögerungsfeld zwischen dem probenseitigen Ende des Strahlführungsrohres (4) und der Probe (15) in das Strahlführungsrohr (4) hinein zurück beschleunigt und haben innerhalb des Strahlführungsrohres wieder genau die selbe Energie wie die Primärelektronen und gelangen deshalb von rückwärts in das Filtersystem (7). Aufgrund der entgegengesetzten Bewegungsrichtung werden diese zurückgestreuten Elektronen jedoch im Magnetsektor (7a) des Filters in entgegengesetzter Richtung abgelenkt und gelangen auf diesem Weg zu einem Primärelektronendetektor (16). Auch dieser Primärelektronendetektor (16) kann in üblicher Weise als Szintillationsdetektor, Halbleiterdetektor oder Mikrokanalplattendetektor ausgebildet sein. Zwischen dem Magnetsektor (7a) und dem Primärelektronendetektor (16) ist noch eine zweite Spaltblende (17) angeordnet, durch die Elektronen mit anderer Energie, die beispielsweise eine Wechselwirkung mit der Probe (15) oder mit der Selektionsblende (8) erfahren haben, ausgefiltert werden.

Bei dem in den Figuren 1 und 2 dargestellten Ausführungsbeispiel der Erfindung ist das dispersive Filter entsprechend der US 4 740 704 ausgebildet. Es handelt sich hierbei um ein sogenanntes Omega Filter, das von der Anmelderin auch in ihrem Transmissionselektronenmikroskop 912 Omega eingesetzt wird. Alternativ kann das Filter (7) auch als sogenanntes Alpha Filter entsprechend der US 4 760 261 oder entsprechend der US 5 449 914 ausgebildet sein.

Beim Ausführungsbeispiel nach Figur 1 ist die erste Kondensorlinse (5) als Magnetlinse ausgebildet. Bei dem in der Figur 3 dargestellten Ausführungsbeispiel ist die Kondensorlinse (24) eine elektrostatische Linse, die in den Strahlerzeuger (21) mit der Kathodenspitze (21a) integriert ist. Diese asymmetrische elektrostatische Immersionslinse (24) ist zwischen der Extraktionselektrode (21) und der Anode (23) angeordnet. Sie weist auf der dem Strahlerzeuger (21) zugewandten Seite einen wesentlich größeren Öffnungsdurchmesser als auf der der Anode (23) zugewandten Seite auf. Auch durch eine solche elektrostatische Immersionslinse (24) wird die Elektronen emittierende Kathodenspitze (21a) direkt vergrößert in die hier nicht mehr dargestellte Eingangsbildebene des nachfolgenden dispersiven Filters abgebildet.

In den Figuren 4a und 4b sind zwei alternative Objektivlinsen dargestellt, die vorzugsweise in Kombination mit der Erfindung zum Einsatz kommen. Der Unterschied zwischen der Objektivlinse (33) in Figur 4a und der Objektivlinse (13) in Figur 1 ist, daß bei der Objektivlinse (33) der äußere Polschuh (33a) verkürzt ist und auf der gleichen Höhe endet wie der innere Polschuh (33b). Dadurch entsteht ein ringförmiger, senkrecht zur strichpunktiert dargestellten optischen Achse ausgerichteter Polschuhspalt (33b). Durch diese Ausbildung des Polschuhspaltes tritt das Magnetfeld in Richtung auf die Probe (35) aus, wodurch eine stärkere Immersion der Probe (35) und dadurch eine Reduzierung des Öffnungsfehlers resultiert. Für die überlagerte elektrostatische Linse sind dann Elektroden (34) als Verlängerung des äußeren Polschuhs (33a) ausgebildet.

Die Objektivlinse (36) in Figur 4b unterscheidet sich von den zuvor beschriebenen Objektivlinsen dadurch, daß das Strahlführungsrohr (4) verlängert ist und erst auf der Höhe des äußeren Polschuhs (36a) der Magnetlinse (36) oder sogar erst dahinter endet. Die elektrostatische Linse zwischen dem probenseitigen Ende des Strahlführungsrohres (4) und der zwischen der Probe (38) und dem Objektiv angeordneten Abbremselektrode (37) entsteht dann erst hinter der Magnetlinse (36). Bei diesem Ausführungsbeispiel liegen die Probe (38) und die Abbremselektrode (37) auf einem gemeinsamen Potential, das gegenüber Massepotential negativ ist. Der Einsatz dieses Objektivs bietet insbesondere bei niedrigsten Zielenergien Vorteile, da auch bei niedrigsten Zielenergien die Kathode auf einem gegenüber Massepotential relativ hohen Potential gehalten werden kann und sich dadurch Streufelder weniger stark negativ bemerkbar machen.

## Patentansprüche

1. Elektronenstrahlgerät, mit einer Elektronenquelle (1, la), einer Kondensorlinse (5, 24), einem Energiefilter (7) und einem Objektiv (13, 33, 36) zur Fokussierung des Elektronenstrahls, in dem der Energiefilter zwischen der Elektronenquelle (1, 1a) und dem Objektiv (13, 33, 36) angeordnet ist, **dadurch gekennzeichnet, dass** der Energiefilter (7) eine Dispersion aufweist und eine erste eingangsseitige Ebene (9) achromatisch in eine erste ausgangsseitige Ebene (10) und eine zweite eingangsseitige Ebene (6) dispersiv in eine zweite ausgangsseitige Ebene (8) abbildet und wobei die Elektronenquelle (1, 1a) von der Kondensorlinse (5, 24) in die erste eingangsseitige Ebene (9) des Energiefilters (7) abgebildet wird.

2. Elektronenstrahlgerät nach Anspruch 1, wobei in der zweiten ausgangsseitigen Ebene eine Blende (8) zur Energiefilterung angeordnet ist.

3. Elektronenstrahlgerät nach Anspruch 1 oder 2, wobei die Elektronenquelle (1, 1a) von der Kondensorlinse (5, 24) vergrößert in die erste eingangsseitige Ebene (9) abgebildet wird.

4. Elektronenstrahlgerät nach einem der Ansprüche 1 bis 3, wobei die Teilchenenergie innerhalb des Filters (7) zwischen 5 und 30 keV beträgt.

5. Elektronenstrahlgerät nach einem der Ansprüche 1 bis 4, wobei die Elektronen im Objektiv (13, 33, 36) oder zwischen dem Objektiv (36) und der zu untersuchenden Probe (15, 35, 38) auf eine geringere Endenergie abgebremst werden.

6. Elektronenstrahlgerät nach einem der Ansprüche 1 bis 5, wobei die Elektronenquelle(1, 1a) vom Objektiv auf die zu untersuchende Probe (15, 35, 38) fokussiert wird und wobei eine Ablenkeinrichtung (14) zum Abrastern der zu untersuchenden Probe (15, 35, 38) vorgesehen ist.

7. Elektronenstrahlgerät nach einem der Ansprüche 1 bis 6, wobei zwischen dem Objektiv (13) und dem Filter (7) ein Detektor (12) zum Nachweis von Sekundärteilchen vorgesehen ist.

8. Elektronenstrahlgerät nach einem der Ansprüche 1 bis 7, wobei ein weiterer Detektor (16) zum Nachweis zurückgestreuter Teilchen vorgesehen ist.

9. Elektronenstrahlgerät nach Anspruch 8, wobei zwischen dem Filter (7) und dem Detektor (16) zum Nachweis zurückgestreuter Teilchen eine Blende (17) zur Energieselektion vorgesehen ist.

10. Elektronenstrahlgerät nach einem der Ansprüche 1 bis 9, wobei der Filter (7) für die Energie der Teilchen eine Dispersion von 5 bis 20 µm/eV, vorzugsweise zwischen 10 und 15 µm/eV aufweist.

## Claims

1. Electron beam device with an electron source (1, 1a), a condenser lens (5, 24), an energy filter (7) and an objective (13, 33, 36) for focusing the electron beam, in which the energy filter is arranged between the electron source (1, 1a) and the objective (13, 33, 36), **characterized in that** the energy filter (7) has a dispersion and a first plane (9) on the input side is projected achromatically into a first plane (10) on the output side and a second plane (6) on the input side is projected dispersively into a second plane (8) on the output side, and wherein the electron source (1, 1a) is projected by the condenser lens (5, 24) into the first plane (9) on the input side of the energy filter (7).

2. Electron beam device according to Claim 1, wherein a diaphragm (8) for energy filtering is arranged in the second plane on the output side.

3. Electron beam device according to Claim 1 or 2, wherein the electron source (1, 1a) is projected by the condenser lens (5, 24), while being magnified, into the first plane (9) on the input side.

4. Electron beam device according to one of Claims 1 to 3, wherein the particle energy inside the filter (7) is between 5 and 30 keV.

5. Electron beam device according to one of Claims 1 to 4, wherein the electrons are decelerated to a lower final energy in the objective (13, 33, 36) or between the objective (36) and the sample (15, 35, 38) to be studied.

6. Electron beam device according to one of Claims 1 to 5, wherein the electron source (1, 1a) is focused by the objective onto the sample (15, 35, 38) to be studied, and wherein a deviating instrument (14) is provided for scanning the sample (15, 35, 38) to be studied.

7. Electron beam device according to one of Claims 1 to 6, wherein a detector (12) for detecting secondary particles is provided between the objective (13) and the filter (7).

8. Electron beam device according to one of Claims 1 to 7, wherein a further detector (16) is provided for detecting back-scattered particles.

9. Electron beam device according to Claim 8, wherein a diaphragm (17) for energy selection is provided between the filter (7) and the detector (16) for detecting back-scattered particles.

10. Electron beam device according to one of Claims 1 to 9, wherein the filter (7) has a dispersion of from 5 to 20 µm/eV, advantageously between 10 and 15 µm/eV, for the energy of the particles.

## Revendications

1. Equipement à faisceau électronique, avec une source d'électrons (1, 1a), une lentille condenseur (5, 24), un filtre d'énergie (7) et un objectif (13, 33, 36) pour focaliser le faisceau électronique, dans lequel le filtre d'énergie est disposé entre la source d'électrons (1, 1a) et l'objectif (13, 33, 36), **caractérisé en ce que** le filtre d'énergie (7) présente une dispersion et reproduit de manière achromatique un premier plan (9) du côté de l'entrée dans un premier plan (10) du côté de la sortie et reproduit de manière dispersive un deuxième plan (6) du côté de l'entrée dans un deuxième plan (8) du côté de la sortie et dans lequel la source d'électrons (1, 1a) est reproduite par la lentille condenseur (5, 24) dans le premier plan (9) du côté de l'entrée du filtre d'énergie (7).

2. Equipement à faisceau électronique selon la revendication 1, dans lequel un diaphragme (8) est disposé dans le deuxième plan du côté de la sortie pour filtrer l'énergie.

3. Equipement à faisceau électronique selon la revendication 1 ou 2, dans lequel la source d'électrons (1, 1a) est reproduite de manière agrandie dans le premier plan (9) du côté de l'entrée par la lentille condenseur (5, 24).

4. Equipement à faisceau électronique selon une des revendications 1 à 3, dans lequel l'énergie des particules à l'intérieur du filtre (7) est comprise entre 5 et 30 keV.

5. Equipement à faisceau électronique selon une des revendications 1 à 4, dans lequel les électrons sont freinés dans l'objectif (13, 33, 36) ou entre l'objectif (36) et l'échantillon à examiner (15, 35, 38) jusqu'à une énergie finale très faible.

6. Equipement à faisceau électronique selon une des revendications 1 à 5, dans lequel la source d'électrons (1, 1a) est focalisée par l'objectif sur l'échantillon à examiner (15, 35, 38) et dans lequel un dispositif de déviation (14) est prévu pour balayer l'échantillon à examiner (15, 35, 38).

7. Equipement à faisceau électronique selon une des revendications 1 à 6, dans lequel un détecteur (12) pour la détection de particules secondaires est prévu entre l'objectif (13) et le filtre (7).

8. Equipement à faisceau électronique selon une des revendications 1 à 7, dans lequel est prévu un autre détecteur (16) pour la détection de particules rétrodiffusées.

9. Equipement à faisceau électronique selon la revendication 8, dans lequel un diaphragme (17) pour la sélection en énergie est prévu entre le filtre (7) et le détecteur (16) pour la détection de particules rétrodiffusées.

10. Equipement à faisceau électronique selon une des revendications 1 à 9, dans lequel le filtre (7) présente, pour l'énergie des particules, une dispersion de 5 à 20 µm/eV, de préférence entre 10 et 15 µm/eV.
